**Europäisches Patentamt**

(19) **European Patent Office**

**Office européen des brevets**

(11) Numéro de publication: **0 112 230**
**B1**

(12) # FASCICULE DE BREVET EUROPÉEN

(45) Date de publication du fascicule du brevet:
**08.04.87**

(51) Int. Cl.⁴: **H 01 J 37/317, H 05 H 3/02**

(21) Numéro de dépôt: **83402328.5**

(22) Date de dépôt: **02.12.83**

(54) **Procédé et dispositif d'obtention de faisceaux de particules de densité spatialement modulée, application à la gravure et à l'implantation ioniques.**

(30) Priorité: **08.12.82 FR 8220564**

(43) Date de publication de la demande:
**27.06.84 Bulletin 84/26**

(45) Mention de la délivrance du brevet:
**08.04.87 Bulletin 87/15**

(84) Etats contractants désignés:
**CH DE FR GB IT LI NL**

(56) Documents cité:
**FR-A-2 235 474**
**US-A-3 551 213**
**US-A-4 074 139**

**PHYSICA, vol. 40, no. 2, 13 décembre 1968, pages 229-233, North-Holland Publishing Co., Amsterdam, NL, L. VRIENS et al: "Excitation to the metastable states and ionization from ground and metastable states in helium"**

(73) Titulaire: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Bruel, Michel, Lotissement Presvert No9, F-38113 Veurey Voroize (FR)**

(74) Mandataire: **Mongrédien, André, c/o BREVATOME 25, rue de Ponthieu, F-75008 Paris (FR)**

**0 112 230**

## Description

La présente invention concerne un procédé et un dispositif d'obtention de faisceaux de particules de densité spatialement modulée. Elle s'applique notamment à la gravure ionique, en particulier à la gravure fine et localisée, dans le domaine de la micro-électronique, ainsi qu'à l'implantation ionique et en particulier au dopage localisé, à l'aide d'une telle implantation.

Par "particules", on entend notamment des atomes, des groupements d'atomes, des molécules, des ions négatifs ou des ions positifs.

Par "faisceau de particules de densité spatialement modulée", on entend un faisceau de particules pour lequel la densité des particules, dans une section transverse donnée dudit faisceau, dépend du point considéré de ladite section. On peut avoir une modulation spatiale "en tout ou rien" ou discontinue, c'est-à-dire une modulation spatiale pour laquelle toute section transverse du faisceau est formée de domaines contenant des particules et isolés les uns des autres. On peut également avoir une modulation spatiale continue, c'est-à-dire une modulation spatiale pour laquelle la densité des particules, dans toute section transverse dudit faisceau, varie de façon continue d'un point à un autre de ladite section.

On connaît une méthode pour obtenir un faisceau de particules de densité spatialement modulée: cette méthode consiste à faire passer le faisceau au travers d'un masque "réticulaire", le faisceau étant ensuite focalisé lorsque l'application envisagée le nécessite. Le masque réticulaire peut être constitué par une plaque percée d'ouvertures adéquates, donnant alors une modulation en tout ou rien, ou par une plaque dont l'absorption pour le faisceau incident varie en fonction du point considéré sur la plaque, donnant alors une modulation spatiale dite analogique.

Cette méthode présente l'inconvénient de rendre impossible la réalisation de certaines modulations. En outre, le masque réticulaire utilisé dans cette méthode se trouve rapidement altéré par le faisceau de particules incident.

On connaît une autre méthode pour obtenir un faisceau de particules de densité spatialement modulée : cette autre méthode consiste à balayer rapidement une portion donnée de l'espace au moyen d'un faisceau fin, tout en modulant l'intensité du faisceau en fonction du temps de façon à obtenir la modulation spatiale désirée dans la portion d'espace balayée par le faisceau.

Cette autre méthode présente l'inconvénient d'être longue et de nécessiter la réalisation d'un faisceau fin et parfaitement contrôlé.

La présente invention a pour but de remédier aux inconvénients des méthodes précédentes et elle vise un procédé et un dispositif d'obtention de faisceaux de particules de densité spatialement modulée.

L'invention a tout d'abord pour objet un procédé d'obtention de faisceaux de particules de densité spatialement modulée, caractérisé en ce qu'il consiste:

- à faire passer les particules d'un faisceau primaire de particules à un premier état énergétique $E_1$, de manière à former un faisceau de particules se trouvant dans ledit premier état énergétique $E_1$,

- à faire passer sélectivement les particules se trouvant dans ledit premier état énergétique $E_1$ à un second état énergétique $E_2$ à l'aide d'un flux lumineux d'intensité spatialement modulée, dirigé sur le faisceau de particules se trouvant dans ledit premier état énergétique $E_1$, et

- à séparer les particules se trouvant dans ledit second état énergétique $E_2$ des particules se trouvant dans ledit premier état énergétique $E_1$ de manière à obtenir un faisceau formé des particules se trouvant dans ledit premier état énergétique $E_1$ et un faisceau formé des particules se trouvant dans ledit second état énergétique $E_2$, ces faisceaux étant distincts et de densité spatialement modulée,

en ce que l'un desdits premier et second états énergétiques $E_1$ et $E_2$ est un état énergétique de longue durée de vie et en ce que l'autre état énergétique est un état ionisé dont l'état d'ionisation diffère de celui de l'état énergétique de longue durée de vie. Ainsi ce dernier peut-il être, de préférence, neutre ou de signe opposé au signe de l'état ionisé, ou encore de même signe que celui-ci mais de multiplicité d'ionisation différente de celle de l'état ionisé (de manière à pouvoir séparer les faisceaux de particules se trouvant respectivement dans les états $E_1$ et $E_2$ par un champ électrique et/ou magnétique par exemple).

Ainsi, dans un premier mode de réalisation le procédé objet de l'invention est caractérisé en ce qu'il consiste:

- à faire passer les particules d'un faisceau primaire de particules, à un état énergétique de longue durée de vie, de manière à former un faisceau de particules se trouvant dans ledit état énergétique de longue durée de vie,

- à faire passer sélectivement les particules se trouvant dans ledit état énergétique de longue durée de vie, à un état ionisé dont l'état d'ionisation diffère de celui de l'état énergétique de longue durée de vie, à l'aide d'un flux lumineux d'intensité spatialement modulée, dirigé sur le faisceau de particules se trouvant dans ledit état énergétique de longue durée de vie, ledit flux lumineux étant composé de photons d'énergie soit au moins égale à la différence entre l'énergie dudit état ionisé et l'énergie dudit état énergétique de longue durée de vie dans le cas d'une transition directe, soit adaptée aux niveaux intermédiaires dans le cas de transitions indirectes, et enfin

- à séparer les particules se trouvant dans ledit état ionisé, des particules demeurant dans ledit état énergétique de longue durée de vie, de manière à obtenir un faisceau formé des particules se trouvant dans ledit état ionisé et un faisceau formé des particules demeurant dans ledit état énergétique de longue durée de vie, ces faisceaux étant distincts et de densité spatialement modulée.

2

Dans le cas de ce premier mode de réalisation, par "état énergétique de longue durée de vie", on entend un état énergétique dont la durée de vie est suffisante pour que les particules se trouvent encore dans cet état au moment où l'on souhaite faire passer sélectivement des particules audit état ionisé. A cet effet, un état énergétique dont la durée de vie est supérieure à 1μs et par exemple d'environ quelques dizaines de microsecondes (de l'ordre de 20 à 50μs) convient en tant qu'état énergétique de longue durée de vie.

Dans un second mode de réalisation, le procédé objet de l'invention est caractérisé en ce qu'il consiste:

- à faire passer les particules d'un faisceau primaire de particules à un état ionisé de manière à former un faisceau de particules se trouvant dans ledit état ionisé,

- à faire passer sélectivement les particules se trouvant dans ledit état ionisé, à un état énergétique de longue durée de vie dont l'état d'ionisation diffère de celui de l'état ionisé, à l'aide d'un flux lumineux d'intensité spatialement modulée, dirigé sur le faisceau de particules se trouvant dans ledit état ionisé, ledit flux lumineux étant composé de photons d'énergie soit au moins égale à la différence entre l'énergie dudit état énergétique de longue durée de vie et l'énergie dudit état ionisé dans le cas d'une transition directe, soit adaptée aux niveaux intermédiaires dans le cas d'une transition indirecte, et

- à séparer les particules demeurant dans ledit état ionisé, des particules se trouvant dans ledit état énergétique de longue durée de vie, de manière à obtenir un faisceau formé de particules se trouvant dans ledit état énergétique de longue durée de vie et un faisceau formé de particules demeurant dans l'état ionisé, ces faisceaux étant distincts et de densité spatialement modulée.

Dans le cas de ce second mode de réalisation particulier, par "état énergétique de longue durée de vie", on entend un état énergétique dont la durée de vie est suffisante pour que les particules se trouvent encore dans cet état au moment où l'on souhaite séparer ces particules des particules demeurant dans l'état ionisé.

Par "état ionisé d'une particule", on entend un état dans lequel la particule a perdu ou gagné un ou plusieurs électrons.

Le premier mode et le second mode de réalisation se caractérisent tous deux par le fait que l'on crée deux populations distinctes à l'intérieur d'un faisceau: les particules à l'état ionisé et les particules dans ledit état énergétique de longue durée de vie, la modulation spatiale étant créée grâce à la séparation de ces deux populations. La différence entre le premier mode et le second mode de réalisation tient uniquement au fait que dans le premier mode, l'état ionisé est le résultat dû au flux lumineux appliqué et que dans le second mode, l'état ionisé est l'état de départ et l'état énergétique de longue durée de vie est le résultat de l'application du flux lumineux.

On voit donc la similitude totale des deux modes de réalisation. Dans ce qui suit à propos du procédé de l'invention on ne se référera, pour plus de clarté, qu'au premier mode de réalisation, étant bien entendu que l'on peut en tirer les conclusions correspondantes quant au second mode de réalisation.

On peut utiliser comme flux lumineux un faisceau lumineux ou plusieurs faisceaux lumineux incidents sur le faisceau de particules se trouvant dans ledit état énergétique de longue durée de vie, à différents endroits de celui-ci, ou au même endroit et selon des directions différentes. L'intensité d'un faisceau lumineux peut être modulée spatialement de façon continue, c'est-à-dire varier de façon continue d'un point à un autre d'une section transverse du faisceau lumineux, ou peut être modulée spatialement de façon discontinue, toute section transverse du faisceau lumineux étant alors formée de domaines isolés les uns des autres, en dehors desquels l'intensité lumineuse est nulle.

La modulation de l'intensité d'un flux lumineux incident sur le faisceau de particules se trouvant dans l'état énergétique de longue durée de vie, entraîne une modulation spatiale de la densité de ce faisceau de particules: certaines particules, sous l'action des photons du flux lumineux, passent à l'état ionisé et d'autres, non atteintes par les photons, demeurent dans ledit état énergétique de longue durée de vie. Après quoi, l'on trie les particules pour former un faisceau de particules dans ledit état ionisé et un faisceau de particules demeurant dans ledit état énergétique de longue durée de vie et l'on peut alors utiliser l'un ou l'autre de ces deux faisceaux de densité spatialement modulée, ou les deux. Bien entendu, le faisceau de particules demeurant dans l'état énergétique de longue durée de vie de longue durée de vie peut comporter des particules qui sont retombées à leur état fondamental, la durée de vie n'étant pas infinie. Par ailleurs, on pourrait remettre en oeuvre le procédé selon l'invention sur le faisceau de particules demeurant dans l'état énergétique de longue duree de vie en ionisant certaines de celle-ci et en les separant des autres. On peut également noter que la modulation de l'intensité du flux lumineux est déterminée en fonction de la modulation spatiale souhaitée pour la densité du faisceau de particules dans l'état ionisé ou pour la densité du faisceau de particules demeurant dans l'état énergétique de longue durée de vie.

La présente invention présente les avantages suivants: l'utilisation d'états énergétiques de longue durée de vie permet d'obtenir une ionisation en deux étapes (mise sur ledit état énergétique de longue durée de vie et ionisation proprement dite) de façon aisée; en outre, le choix d'un état énergétique de longue durée de vie voisin de l'état ionisé permet d'utiliser des photons appartenant au spectre visible ou à l'ultraviolet proche pour l'ionisation, et donc d'utiliser des moyens optiques classiques pour traiter le ou les faisceaux lumineux utilisés en tant que flux lumineux; enfin, la modulation de l'intensité du ou des faisceaux lumineux se traduit directement en une modulation spatiale du faisceau des particules se trouvant dans ledit état énergétique de longue durée de vie et il est donc possible de réaliser, quant à cette modulation spatiale, tout ce qui est réalisable en imagerie optique.

Par ailleurs, le problème de l'altération d'un masque par un faisceau de particules ne se pose pas dans l'invention, puisqu'un tel masque n'est pas utilisé dans celle-ci. En outre, la présente invention permet d'obtenir

3

rapidement un faisceau de densité spatialement modulée, à partir d'un faisceau qui n'a pas besoin d'être fin ni d'être parfaitement contrôlé.

Selon une caractéristique préférée du procédé objet de l'invention, ledit état énergétique de longue durée de vie est un état excité métastable. En effet, un état excité d'une particule, telle qu'un atome par exemple, dont la transition vers un autre état excité ou vers l'état fondamental est autorisée par les régles de sélection du rayonnement dipolaire, a une durée de vie très courte. Au contraire, un état excité métastable, dont la transition n'est pas autorisée, a une durée de vie bien supérieure aux précédentes, et pouvant dépasser 1s, voire $10^5$s, suivant l'atome considéré.

On peut passer directement de l'état fondamental d'une particule à un état métastable, par choc électronique ou photonique, les électrons étant toutefois plus efficaces que les photons. Cet état métastable peut également être atteint à partir d'un état radiatif dont la désexcitation conduit précisément, par une suite de transitions radiatives, audit état métastable.

Selon une caractéristique particulière du procédé objet de l'invention, les particules du faisceau primaire sont électriquement neutres et dans leur état fondamental, et l'on fait passer ces particules audit état excité métastable, à partir de leur état fondamental, par bombardement électronique, (ledit premier état énergétique $E_1$ étant constitué par ledit état excité métastable et ledit second état énergétique $E_2$ étant alors ledit état ionisé).

Selon une autre caractéristique particulière, les particules du faisceau primaire sont électriquement chargées et l'on fait passer ces particules audit état excité métastable par bombardement électronique, après avoir neutralisé les particules du faisceau primaire par échange de charges dans un gaz de particules du même type, (ledit premier état énergétique $E_1$ étant constitué par ledit état excité métastable et ledit second état énergétique $E_2$ étant alors ledit état ionisé). L'intérêt d'utiliser un faisceau primaire de particules chargées tient au fait que de telles particules peuvent être accélérées préalablement à la modulation spatiale du faisceau.

Selon une autre caractéristique particulière, ledit état ionisé est l'état de première ionisation.

Selon une autre caractéristique particulière, les particules se trouvant dans ledit état ionisé sont séparées des particules se trouvant dans ledit état énergétique de longue durée de vie à l'aide d'au moins l'un des champs pris dans le groupe comprenant les champs électriques et les champs magnétiques.

Selon une autre caractéristique particulière, l'intensité du flux lumineux est modulée spatialement par passage dudit flux lumineux à travers un masque optique plus simplement appelé "masque".

Selon une autre caractéristique particulière, la modulation spatiale d'intensité du flux lumineux est obtenue par une méthode fondée sur la nature ondulatoire de la lumière, par exemple par une technique d'interférométrie ou d'holographie.

Selon une autre caractéristique particulière le flux lumineux d'intensité modulée est obtenu en dirigeant vers l'axe du faisceau de particules se trouvant dans ledit premier état énergétique $E_1$ deux faisceaux de lumière cohérente issus du même faisceau lumineux primaire, ceci de façon symétrique par rapport à l'axe du faisceau de particules se trouvant dans ledit premier état énergétique $E_1$, de façon à obtenir ainsi des zones alternativement lumineuses et sombres parallèles à l'axe du faisceau de particules se trouvant dans ledit premier état énergétique $E_1$.

Selon une autre caractéristique particulière, lesdites particules sont des atomes d'au moins un gaz rare. Le tableau suivant indique des états métastables de certains gaz rares, leur énergie $E_m$ exprimée en eV, leur durée de vie T exprimée en secondes, et pour chaque atome de gaz rare, l'énergie de première ionisation $E_i$ exprimée en eV, les différences $E_i - E_m$ (en eV) et les longueurs d'onde $\lambda$ exprimées en $\mu$m des photons permettant les transitions des états métastables vers l'état (ou niveau) de première ionisation.

**Tableau**

| Gaz rare | Etat fondamental | Etats métastables | $E_m$ | T | $E_i$ | $E_i-E_m$ | $\lambda$ |
|---|---|---|---|---|---|---|---|
| He | $1^1S_0$ | $2^3S_1$ | 19,82 | $6.10^5$ | 24,6 | 4,78 | 0,260 |
| | | $2^1S^0$ | 20,61 | $2.10^{-2}$ | | 3,99 | 0,310 |
| Ne | $2^1S_0$ | $3^3P_2^0$ | 16,62 | 0,8 | 21,564 | 4,944 | 0,251 |
| | | $3^3P_0^0$ | 16,72 | 0,8· | | 4,844 | 0,256 |
| A | $3^1S_0$ | $4^3P_2^0$ | 11,55 | 1,3 | 15,755 | 4,205 | 0,295 |
| | | $4^3P_0^0$ | 11,72 | 1,3 | | 4,035 | 0,301 |
| Kr | $4^1S_0$ | $5^3P_2^0$ | 9,92 | 1 | 13,999 | 4,079 | 0,304 |
| | | $5^3P_0^0$ | 10,56 | 1 | | 3,439 | 0,361 |
| Xe | $5^1S_0$ | $6^3P_2^0$ | 8,32 | inconnu | 12,129 | 3,809 | 0,326 |
| | | $6^3P_0^0$ | 9,45 | inconnu | | 2,679 | 0,463 |

Il est à noter que des sources émettrices de photons de telles longueurs d'onde sont connues dans l'état de la technique. Par ailleurs, les sections efficaces d'excitation par des électrons, des états métastables des gaz rares comme l'hélium ou l'argon, sont également connues dans l'état de la technique. A titre d'exemple, la section efficace d'excitation des états métastables de l'argon par des électrons dont l'énergie cinétique vaut 22 eV, est de l'ordre de $2.10^{-17}$ cm$^2$, valeur qui est assez importante. Les sections efficaces d'ionisation des états métastables des gaz rares sont elles aussi connues dans l'état de la technique.

La présente invention concerne par ailleurs un dispositif d'obtention de faisceaux de particules de densité spatialement modulée, caractérisé en ce qu'il comprend:

- des moyens pour produire un faisceau primaire de particules,

- des moyens pour faire passer les particules de ce faisceau primaire à un premier état énergétique $E_1$ de manière à former un faisceau de particules se trouvant dans ledit premier état énergétique $E_1$,

- des moyens pour produire un flux lumineux composé de photons aptes à faire passer les particules se trouvant dans ledit premier état énergétique $E_1$, à un second état énergétique $E_2$, et pour diriger ce flux lumineux sur le faisceau de particules se trouvant dans le premier état énergétique $E_1$,

- des moyens de modulation spatiale de l'intensité dudit flux lumineux, interposés entre les moyens pour produire et diriger ce flux lumineux et le faisceau de particules se trouvant dans le premier état énergétique $E_1$, de manière à faire passer sélectivement les particules se trouvant dans le premier état énergétique $E_1$ au second état énergétique $E_2$, et

- des moyens de séparation des particules se trouvant dans le second état énergétique $E_2$, des particules se trouvant dans le premier état énergétique $E_1$, de façon à obtenir un faisceau formé des particules se trouvant dans le premier état énergétique $E_1$ et un faisceau formé des particules se trouvant dans le second état énergétique $E_2$, ces faisceaux étant distincts et de densité spatialement modulée,

l'un des premier et second états énergétiques $E_1$ et $E_2$ étant un état énergétique de longue durée de vie et l'autre état énergétique étant un état ionisé dont l'état d'ionisation diffère de celui de l'état énergétique de longue durée de vie.

5

Dans un premier mode de réalisation, le dispositif objet de l'invention est caractérisé en ce qu'il comprend:

- des moyens pour produire un faisceau primaire de particules,
- des moyens pour faire passer les particules de ce faisceau primaire, à un état énergétique de longue durée de vie, de manière à former un faisceau de particules se trouvant dans ledit état énergétique de longue durée de vie,
- des moyens pour produire un flux lumineux composé de photons aptes à ioniser les particules se trouvant dans ledit état énergétique de longue durée de vie, et pour diriger ce flux lumineux sur ledit faisceau de particules se trouvant dans ledit état énergétique de longue durée de vie,
- des moyens de modulation spatiale de l'intensité dudit flux lumineux, interposés entre les moyens pour produire et diriger ce flux lumineux et le faisceau de particules se trouvant dans ledit état énergétique de longue durée de vie, de manière à faire passer sélectivement les particules se trouvant dans ledit état énergétique de longue durée de vie, à un état ionisé, et
- des moyens de séparation des particules se trouvant dans ledit état ionisé, des particules demeurant dans ledit état énergétique de longue durée de vie, de façon à obtenir un faisceau formé des particules se trouvant dans ledit état ionisé et un faisceau formé des particules demeurant dans ledit état énergétique de longue durée de vie, ces faisceaux étant distincts et de densité spatialement modulée, l'état ionisé ayant un état d'ionisation différent de celui de l'état énergétique de longue durée de vie.

En ce qui concerne le premier mode de réalisation du dispositif objet de l'invention correspondant d'ailleurs au premier mode de réalisation du procédé objet de l'invention:

Selon un mode de réalisation particulier, ledit flux lumineux est constitué par au moins un faisceau lumineux qui est dirigé vers le faisceau de particules se trouvant dans ledit état énergétique de longue durée de vie transversalement à celui-ci.

Selon un autre mode de réalisation particulier, le flux lumineux est un faisceau lumineux, ce dernier ainsi que le faisceau de particules se trouvant dans ledit état énergétique de longue durée de vie sont colinéaires et ont des sens de propagation opposés, et le dispositif comporte en outre successivement des moyens d'ionisation, des moyens d'accélération et des moyens de déviation du faisceau des particules demeurant dans ledit état énergétique.

Selon un autre mode de réalisation particulier, le flux lumineux est un faisceau lumineux, le faisceau de particules se trouvant dans ledit état énergétique de longue durée de vie et le faisceau lumineux sont prévus pour se propager selon une même direction et selon des sens opposés, le faisceau de particules se trouvant dans ledit état énergétique de longue durée de vie est rendu convergent selon un angle α, le faisceau lumineux est rendu divergent selon le même angle α et prévu en outre pour être confondu avec le faisceau de particules se trouvant dans ledit état énergétique de longue durée de vie, et les moyens de séparation consistent en des moyens de déviation des particules se trouvant dans ledit état ionisé. Alors, de préférence, les moyens de modulation spatiale de l'intensité du faisceau lumineux consistent en un masque pourvu de motifs dont la taille est prévue pour que ces motifs n'entraînent qu'une faible diffraction lumineuse. La convergence du faisceau de particules se trouvant dans ledit état énergétique de longue durée de vie permet alors de réduire la taille des "motifs" présents dans ce faisceau après sa modulation.

L'homme de l'art pourrait bien entendu concevoir un dispositif pour la mise en oeuvre du second mode de réalisation du procédé objet de l'invention.

L'invention sera mieux comprise à la lecture de la description qui suit, d'exemples de realisation donnés à titre indicatif et non limitatif, en référence aux dessins annexés sur lesquels:

- la figure 1 est une vue schématique d'un mode de réalisation particulier du dispositif objet de l'invention,
- la figure 2 est une vue schématique d'un masque prévu pour la modulation de l'intensité d'un faisceau lumineux utilisé dans le dispositif représenté sur la figure 1,
- la figure 3a est une vue schématique de l'interaction d'un faisceau de particules utilisé dans le dispositif représenté sur la figure 1 avec deux faisceaux lumineux d'intensités spatialement modulées,
- la figure 3b est une vue schématique de la section transverse d'un faisceau de particules de densité spatialement modulée, obtenu grâce à ladite interaction,
- la figure 4 est une vue schématique d'un autre mode de réalisation particulier du dispositif objet de l'invention,
- la figure 5a est une vue schématique d'un masque prévu pour la modulation de l'intensité d'un faisceau lumineux utilisé dans le dispositif représenté sur la figure 4,
- la figure 5b est une vue schématique de la section transverse d'un faisceau de particules de densité spatialement modulée, obtenu grâce à ce faisceau lumineux d'intensité modulée,
- la figure 6 est une vue schématique d'un autre mode de réalisation particulier du dispositif objet de l'invention, et
- la figure 7 est une vue à plus grande échelle d'une partie du dispositif représenté sur la figure 6.

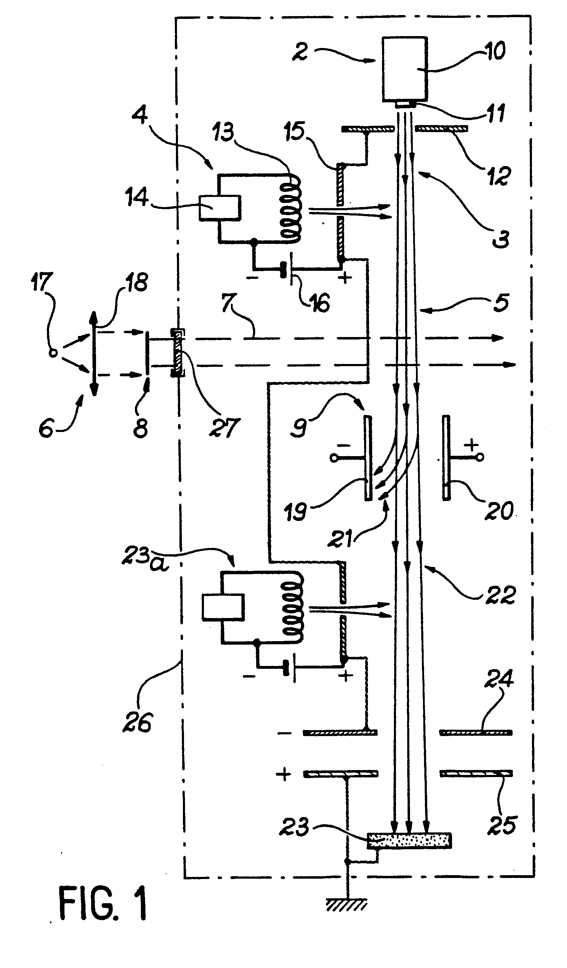

Sur la figure 1, on a représenté schématiquement un mode de réalisation particulier du dispositif objet de l'invention. Il comprend essentiellement:

- des moyens 2 pour produire un faisceau primaire 3 de particules,
- des moyens 4 pour faire passer les particules de ce faisceau primaire 3 à un état énergétique de longue durée de vie, un état excité métastable de préférence, de manière à former un faisceau 5 de particules se trouvant dans cet état métastable,
- des moyens 6 pour produire un faisceau lumineux 7 composé de photons aptes à ioniser les particules se trouvant dans l'état métastable, et pour diriger ce faisceau lumineux 7 sur ledit faisceau 5 de particules se trouvant dans l'état métastable,

- des moyens 8 de modulation spatiale de l'intensité dudit faisceau lumineux 7, interposés entre les moyens 6 pour produire et diriger ce faisceau lumineux 7 et le faisceau 5 de particules se trouvant dans l'état métastable, de manière à faire passer sélectivement des particules se trouvant dans l'état métastable, à un état ionisé, et

- des moyens 9 de séparation des particules se trouvant dans l'état ionisé, des particules demeurant dans l'état excité métastable.

Les particules du faisceau primaire 3 sont par exemple des atomes (électriquement neutres) d'un gaz rare tel que l'hélium. Les moyens 2 pour produire ce faisceau primaire 3 consistent en une source à effusion d'atomes d'hélium, comportant un réservoir 10 d'hélium gazeux, muni d'une buse 11, et un collimateur 12 pour délimiter le faisceau primaire 3 d'atomes d'hélium.

Les moyens 4 pour faire passer les atomes d'hélium à un état excité métastable, par exemple l'état $2^3S_1$, consistent en une source d'électrons comportant un filament 13 émetteur d'électrons lorsqu'il est chauffé à l'aide d'un générateur de courant 14, et une électrode percée 15 prévue pour être traversée par les électrons issus du filament 13. L'électrode 15 est portée à un potentiel électrique positif de l'ordre de 20V par rapport au filament 13, au moyen d'un générateur de tension continue 16, de manière à accélérer les électrons issus du filament 13. La source 4 d'électrons est bien entendu orientée de façon à envoyer les électrons accélérés qu'elle produit sur le faisceau primaire 3.

Les moyens 6 pour produire et diriger le faisceau lumineux 7 comportent une source lumineuse 17, émettant des photons de 0,260 µm de longueur d'onde, suivie par une optique 18, de manière à former le faisceau lumineux 7 et le diriger perpendiculairement sur le faisceau 5 d'atomes d'hélium dans l'état métastable.

Les moyens 8 de modulation spatiale de l'intensité du faisceau lumineux 7 sont constitués par un masque qui sera décrit par la suite. Enfin, les moyens 9 de séparation consistent en deux plaques de déflexion 19 et 20, l'une portée à une haute tension positive, l'autre à une haute tension négative.

Les atomes d'hélium issus de la source à effusion 2 sont donc tout d'abord excités par les électrons émis par la source d'électrons 4 et passent à l'état métastable. Les photons du faisceau lumineux 7 ionisent ensuite sélectivement ces atomes d'hélium dans l'état métastable: certains de ces atomes métastables deviennent des ions He$^+$ et les autres demeurent dans l'état métastable He$^*$, selon une configuration imposée par le masque 8. Après quoi, les ions He$^+$ et les atomes métastables He$^*$ passent entre les plaques 19 et 20. Le champ électrique existant entre ces plaques 19 et 20 dévie les ions He$^+$ mais pas les atomes métastables He$^*$. On obtient ainsi un faisceau 21 d'ions He$^+$ et un faisceau 22 d'atomes d'hélium He$^*$ demeurant dans l'état métastable, ces faisceaux 21 et 22 ayant tous deux une densité spatialement modulée.

Lorsque l'on souhaite utiliser le faisceau 22 d'atomes He$^*$ demeurant dans l'état métastable pour réaliser par exemple une gravure d'un circuit intégré 23 ou une implantation d'ions dans ce circuit 23, on peut ioniser les atomes métastables He$^*$ du faisceau 22 par bombardement électronique, au moyen d'une autre source d'électrons 23a du genre de la source d'électrons 4, puis accélérer les ions formés au moyen d'un champ électrique créé entre deux plaques 24 et 25 percées pour permettre le passage des ions He$^+$ formés, la première plaque 24 se trouvant sur le passage de ceux-ci étant portée à un potentiel électrique négatif de l'ordre de 30 kV par exemple, par rapport à la plaque suivante 25, le circuit intégré 23 étant bien entendu placé à la suite de cette seconde plaque 25, sur la trajectoire du faisceau 22. On pourrait également utiliser le faisceau 21 d'ions He$^+$ de densité spatialement modulée pour le même type d'application, en accélérant convenablement ce faisceau 21 après sa déviation par les plaques déflectrices 19 et 20.

De façon connue dans l'état de la technique, le faisceau primaire 3 est émis dans une enceinte 26 dans laquelle on a fait le vide à l'aide de pompes non représentées, la pression dans l'enceinte 26 étant par exemple de l'ordre de $10^{-4}$Pa, et le bombardement électronique par la source 4, l'irradiation par le faisceau lumineux 7, la séparation des atomes métastables He$^*$ et des ions He$^+$, le bombardement électronique par l'autre source 23a et l'accélération par les plaques 24 et 25, sont bien entendu effectués dans ladite enceinte 26 dans laquelle se trouve également le circuit intégré 23 servant de cible. Pour une plus grande facilité de réalisation et d'utilisation, la source lumineuse 17, l'optique 18 et le masque 8 peuvent être disposés à l'extérieur de cette enceinte 26, la lumière issue de la source 17 traversant alors ladite enceinte 26 par un hublot 27 par exemple en quartz. Pour que les ions He$^+$ ne soient pas soumis à des potentiels électriques flottants, on établit une liaison électrique entre le collimateur 12 et l'électrode percée 15, entre cette dernière et l'électrode homologue de la source d'électrons 23a, entre cette électrode homologue et la première plaque 24, et entre la seconde plaque 25 et le circuit 23, ce dernier étant mis à la masse.

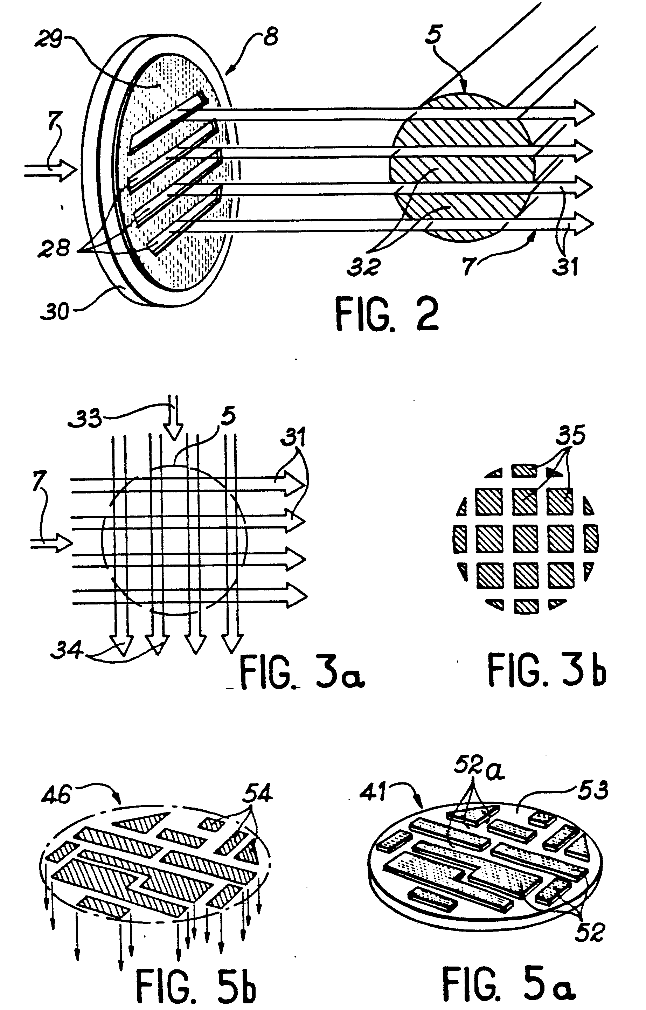

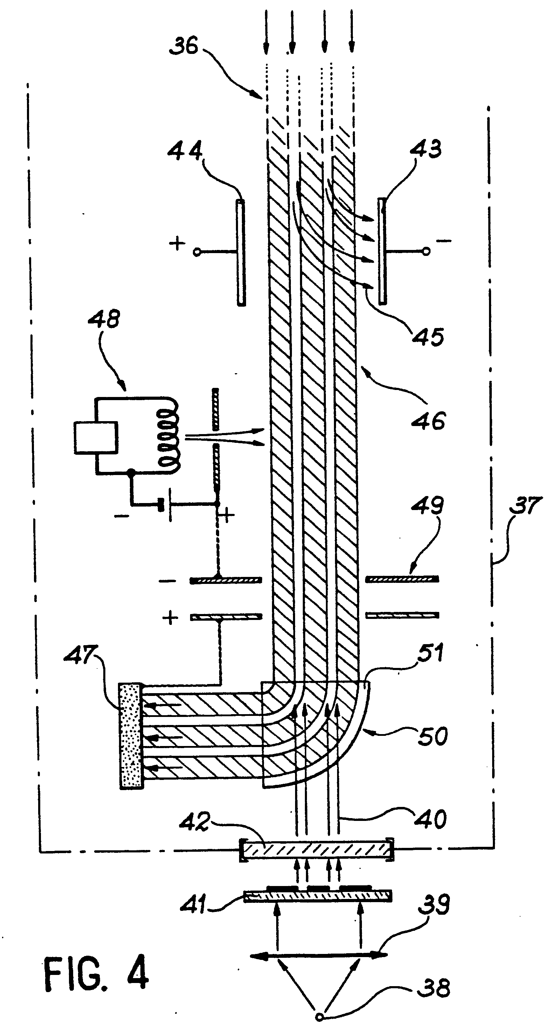

Sur la figure 2, on a représenté schématiquement le masque 8. Il comporte une pluralité de fentes 28 longitudinales et parallèles entre elles, de forme par exemple rectangulaire, pratiquées dans une matière 29 opaque à la lumière utilisée, cette matière 29 étant disposée sur un support plan 30 transparent à ladite lumière. Le masque 8 est disposé sur la trajectoire du faisceau lumineux 7, perpendiculairement à ce dernier, et orienté de façon que les fentes 28 soient parallèles au faisceau 5 des atomes d'hélium He$^*$ dans l'état métastable. En traversant le masque 8, le faisceau 7 est modulé spatialement: il est divisé en une pluralité de sous-faisceaux 31 parallèles qui viennent interagir avec le faisceau 5 d'atomes He$^*$ métastables, en ionisant les atomes He$^*$ métastables qu'ils rencontrent sur leur passage. Après élimination des ions He$^+$ grâce aux plaques déflectrices 19 et 20 (figure 1), il subsiste donc un faisceau d'atomes métastables He$^*$, constitué d'une pluralité de tranches 32 longitudinales parallèles entre elles, dont la vue en coupe est hachurée sur la figure 2.

Au lieu d'un seul faisceau lumineux, on peut en utiliser plusieurs, pour réaliser d'autres modulations spatiales du faisceau 5 d'atomes He* métastables. On peut par exemple utiliser un autre faisceau lumineux 33 (figure 3a) dont l'intensité est modulée par un masque non représenté, conforme au masque 8 (figure 2), et qui est émis par des moyens non représentés, conformes aux moyens 6 (figure 1). Les moyens d'émission et les masques sont disposés de façon que les faisceaux lumineux 7 et 33 tombent sur le faisceau 5 d'atomes d'hélium métastables, perpendiculairement à ce faisceau 5 et dans la même portion de celui-ci (ou dans des portions différentes) et soient par exemple perpendiculaires l'un à l'autre, les masques étant disposés de manière que leurs fentes soient parallèles au faisceau 5 d'atomes d'hélium métastables. Comme on l'a expliqué précédemment, chaque faisceau lumineux 7 ou 33 est formé, après traversée du masque qui lui est associé, de sous-faisceaux 31 ou 34. Ces sous-faisceaux vont ioniser les atomes métastables He* qu'ils rencontrent sur leur passage et, après élimination des ions He+ formés, il subsiste un faisceau d'atomes métastables He* de densité spatialement modulée, constitué d'une pluralité de sous-faisceaux 35 (figure 3b) parallèles et isolés les uns des autres, dont la vue en coupe est hachurée sur la figure 3b.

Sur la figure 4, on a représenté schématiquement un autre mode de réalisation particulier du dispositif objet de l'invention. Les particules considérées sont encore des atomes d'hélium à titre d'exemple. Le dispositif selon l'invention représenté sur la figure 4 comporte des moyens pour produire un faisceau 36 d'atomes d'hélium dans un état métastable dans une enceinte 37 dans laquelle on a fait le vide à l'aide de pompes non représentées, de manière à obtenir une pression de l'ordre de $10^{-4}$Pa dans cette enceinte 37. Les moyens pour produire le faisceau 36 d'atomes d'hélium métastables ne sont pas représentés et sont constitués par une source à effusion d'atomes d'hélium et par une source d'électrons, conformes à celles qui ont précédemment été décrites en relation avec la figure 1.

Le dispositif selon l'invention représenté sur la figure 4 comporte également des moyens constitués par une source lumineuse 38 et une optique 39 respectivement conformes à la source lumineuse 17 et à l'optique 18 de la figure 1, pour former un faisceau lumineux parallèle 40. La source lumineuse 38 et l'optique 39 sont disposées de manière que le faisceaux lumineux 40 émis soit colinéaire au faisceau 36 d'atomes d'hélium métastables mais se propage en sens contraire de ce dernier, les deux faisceaux venant donc à la rencontre l'un de l'autre. Un masque 41 est interposé sur la trajectoire du faisceau lumineux 40 pour moduler l'intensité de celui-ci avant que ce faisceau lumineux 40 n'interagisse avec le faisceau 36 d'atomes d'hélium métastables. Pour faciliter la réalisation et l'utilisation du dispositif, la source lumineuse 38, l'optique 39 et le masque 41 sont placés à l'extérieur de cette enceinte 37 et le faisceau lumineux 40 pénètre dans celle-ci par l'intermédiaire d'un hublot 42 par exemple en quartz dont elle est pourvue. Comme on l'a expliqué précédemment, certains atomes d'hélium passent de l'état métastable à l'état ionisé. Les ions He+ obtenus sont déviés au moyen de plaques déflectrices 43 et 44 disposées de part et d'autre du faisceau d'atomes d'hélium métastables et respectivement soumises à une haute tension négative et à une haute tension positive, et forment ainsi un faisceau 45 d'ions He+ que l'on peut éventuellement utiliser, après accélération, pour une implantation ionique par exemple.

A la sortie des plaques déflectrices 43 et 44, on obtient également un faisceau 46 de densité spatialement modulée, formé d'atomes d'hélium qui, n'ayant pas été atteints par les photons du faisceaux lumineux 40, demeurent dans l'état métastable. Ils peuvent être utilisés par exemple pour une implantation ionique dans un circuit intégré 47 servant de cible, après avoir été ionisés par des moyens d'ionisation 48 par exemple constitues par une source d'électrons énergétiques, puis accélérés par des moyens 49 d'accélération tels qu'un champ électrique obtenu à l'aide de plaques conformes aux plaques 24 et 25 de la figure 1 entre lesquelles est appliquée une tension de l'ordre de 30 kV par exemple, et enfin défléchis en direction du circuit intégré 47, grâce à des moyens 50 de déviation par exemple constitués par un aimant comportant deux pièces polaires entre lesquelles passent les ions destinés à l'implantation et dont une seule, portant la référence 51, est représentée sur la figure 4. Pour que les ions He+ ne soient pas soumis à des potentiels électriques flottants, on établit une liaison électrique entre l'électrode percée, dont est munie la source d'électrons 48, et la plaque homologue de la plaque 24 (figure 1) et faisant partie des moyens 49 d'accélération, et entre la plaque homologue de la plaque 25 (figure 1) et faisant partie desdits moyens 49, et le circuit 47.

Sur la figure 5a, on a représenté schématiquement un mode de réalisation particulier du masque 41 de la figure 4. Il comporte une pluralité de domaines 52 séparés les uns des autres, faits d'une matière opaque à la lumière issue de la source 38 (figure 4) et déposée sur un support 53 transparent à cette lumière. Le masque 41 comporte donc une pluralité de domaines opaques 52 séparés par des domaines transparents 52a. Revenant à la figure 4, on voit que le "dessin" du masque 41, constitué par l'ensemble des domaines opaques 52, s'imprime directement dans le faisceau 36 d'atomes d'hélium métastables: la modulation spatiale du faisceau 46 composé d'atomes d'hélium demeurant dans l'état métastable est l'image exacte du masque 41. On voit sur la figure 5b une section de ce faisceau 46. Cette section comporte effectivement une pluralité de domaines 54 disjoints, homologues des domaines 52 du masque 41.

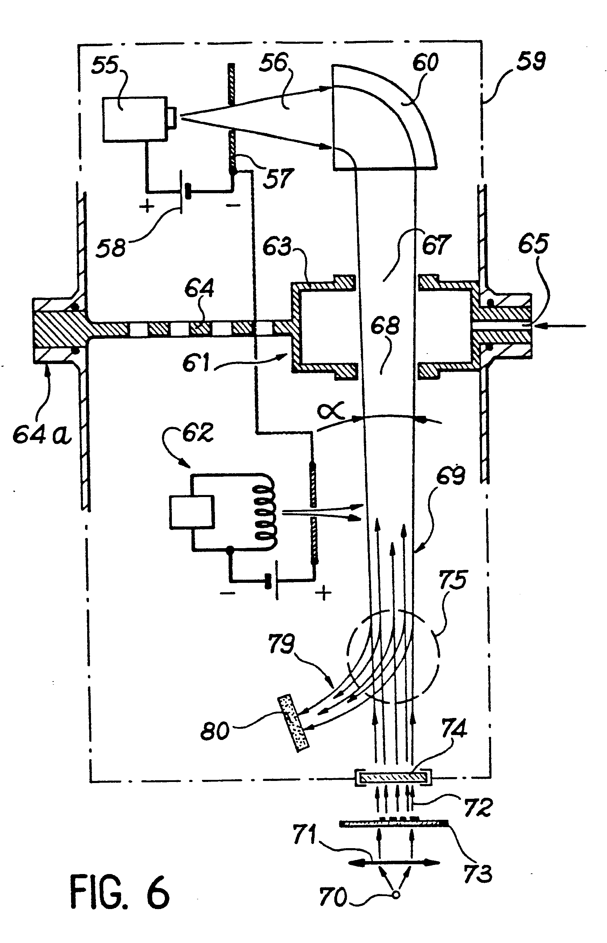

Sur la figure 6, on a représenté schématiquement un autre mode de réalisation particulier du dispositif objet de l'invention. Dans ce mode de réalisation, les particules considérées sont électriquement chargées. Ce sont par exemple des atomes d'hélium une fois ionisés, c'est-à-dire des ions He+. Le dispositif selon l'invention représenté sur la figure 6 comporte des moyens 55 pour produire un faisceau primaire 56 d'ions He+, ces moyens consistant en une source d'ions He+ connue dans l'état de la technique. Le faisceau primaire 56 est accéléré à sa sortie de la source 55, par une électrode 57 percée pour permettre le passage du faisceau primaire 56 et portée à un potentiel négatif, par exemple de l'ordre de 30 kV, par rapport à la source d'ions 55, au moyen d'un générateur de tension 58. Le faisceau primaire 56 est bien entendu émis dans une enceinte 59 dans laquelle on a fait le vide au moyen de pompes non représentées, la pression d'hélium résiduelle dans l'enceinte étant de l'ordre de $10^{-4}$Pa par exemple. Le faisceau primaire 56, divergent à sa sortie de la source d'ions 55 est rendu convergent selon un angle $\alpha$ au moyen d'un champ magnétique de focalisation engendré par un aimant dont on a représenté l'une des pièces polaires 60 sur la figure 6.

Le dispositif selon l'invention représenté sur cette figure 6 comporte également des moyens pour faire passer les ions He$^+$ du faisceau primaire 56, à l'état d'atomes d'hélium He$^*$ dans un état excité métastable, ces moyens comportant des moyens 61 de neutralisation des ions He$^+$ et des moyens 62 d'excitation des atomes d'hélium résultant de la neutralisation des ions He$^+$.

La neutralisation des ions He$^+$ est effectuée dans l'hélium gazeux: les moyens 61 de neutralisation se composent d'une chambre 63 placée dans l'enceinte 59, sur la trajectoire du faisceau primaire 56, après la focalisation de celui-ci. La chambre 63 est maintenue dans l'enceinte 59 au moyen d'un flasque 64 percé de part en part, afin de permettre le maintien d'une même pression, de l'ordre de $10^{-4}$Pa, de part et d'autre de ce flasque 64, ce dernier étant lui-même rendu solidaire de l'enceinte 59 au moyen d'une bride 64a. La chambre 63 contient de l'hélium gazeux sous une pression de l'ordre de $10^{-1}$ Pa, cet hélium gazeux étant introduit dans la chambre 63 par un conduit 65. La chambre 63 est pourvue de deux ouvertures 67 et 68 situées en regard l'une de l'autre sur deux côtés opposés de cette chambre 63, ces deux ouvertures étant disposées dé manière à se trouver sur la trajectoire du faisceau primaire 56. Les deux ouvertures 67 et 68 ont des dimensions adaptées à la taille du faisceau primaire 56. On maintient un bon vide dans le reste de l'enceinte 59 en limitant le plus possible la taille des ouvertures 67 et 68 et en munissant l'enceinte 59 de moyens de pompage permettant de très grandes vitesses de pompage de cette enceinte 59.

Les moyens 62 d'excitation des atomes d'hélium résultant de la neutralisation des ions He$^+$ consistent en une source d'électrons, du genre de la source 4 d'électrons de la figure 1, permettant de bombarder les atomes d'hélium par des électrons pour les faire passer à un état métastable. On obtient ainsi un faisceau 69 d'atomes d'hélium dans un état métastable, ce faisceau convergeant selon l'angle $\alpha$. Pour que les ions He$^+$ ne soient pas soumis à des potentiels électriques flottants, on établit une liaison électrique entre l'électrode percée 57 et l'électrode percée dont est munie la source d'électrons 62.

Le dispositif selon l'invention comprend en outre des moyens constitués par une source lumineuse 70 associée à une optique 71, pour produire un faisceau lumineux 72 qui diverge selon ledit angle $\alpha$ à partir de l'optique 71. Un masque 73, du genre du masque 41 de la figure 4 est placé à la suite de l'optique 71 pour moduler l'intensité du faisceau lumineux 72. La lumière émise par la source 70 a une longueur d'onde de 0,260 µm. Cette source 70 et l'optique 71 sont disposées de manière que le faisceau lumineux 72 d'intensité modulée et le faisceau 69 d'atomes d'hélium métastables se propagent selon une même direction mais selon des sens opposés et que ces faisceaux 69 et 72 soient en outre confondus (ce qui est possible étant donné que l'angle de convergence de l'un est égal à l'angle de divergence de l'autre).

La source lumineuse 70, l'optique 71 et le masque 73 sont situés à l'extérieur de l'enceinte 59 pour simplifier la réalisation et l'utilisation du dispositif. Cette enceinte 59 est pourvue d'un hublot 74 par exemple en quartz, pour permettre le passage du faisceau lumineux 72. Celui-ci interagit avec le faisceau 69 d'atomes d'hélium métastables He$^*$, en ionisant ces derniers.

Le dispositif selon l'invention représenté sur la figure 6 comporte également des moyens 75 de déviation des ions He$^+$ ainsi formés. Ces moyens 75 sont symbolisés par un cercle en trait mixte sur la figure 6 et consistent par exemple en un aimant créant donc un champ magnétique de déflexion.

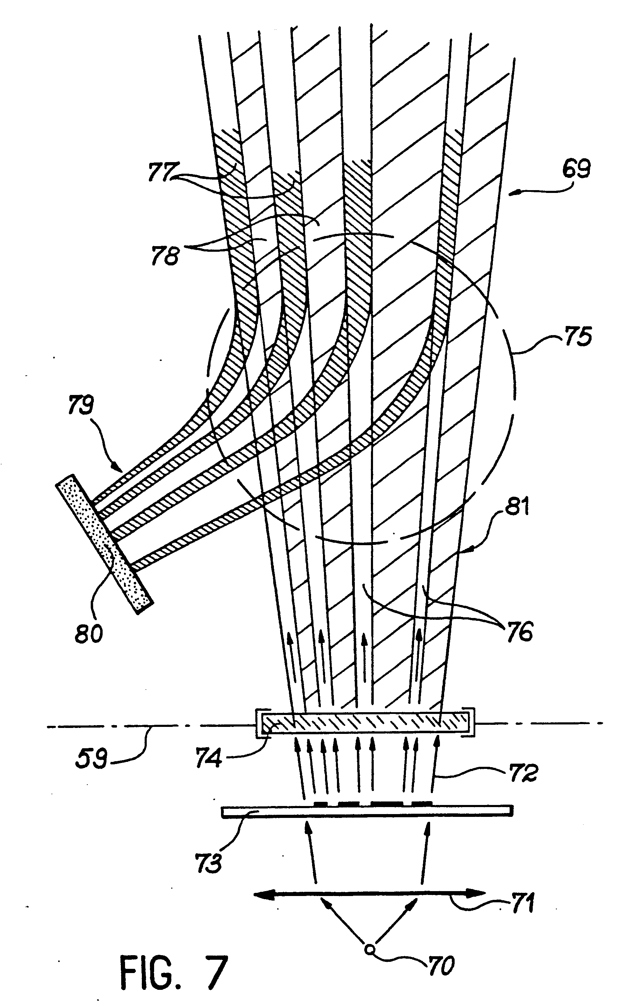

Sur la figure 7, on a représenté à plus grande échelle la zone dans laquelle se produit cette déflexion. Le faisceau lumineux 72 dont l'intensité est spatialement modulée par le masque 73, se compose d'une pluralité de sous-faisceaux 76 qui ionisent les atomes métastables du faisceau 69 d'atomes d'hélium métastables qu'ils rencontrent sur leur passage, créant ainsi des canaux 77 d'oins He$^+$, séparés par d'autres canaux 78 formés par les atomes métastables He$^*$ non atteints par les photons du faisceau lumineux 72 et demeurant donc dans l'état métastable. L'aimant 75 dévie les ions He$^+$ formés, les trajectoires des atomes métastables demeurant quant à elles inchangées. On obtient ainsi un faisceau 79 d'ions He$^+$ de densité spatialement modulée, que l'on peut envoyer sur une cible 80 telle qu'un circuit intégré, pour y effectuer une implantation ionique ou pour sensibiliser une résine déposée sur ledit circuit afin de réaliser sur ce dernier des motifs de taille pouvant être inférieure à 1µm. On obtient également un faisceau 81 de densité spatialement modulée, formé par les atomes d'hélium He$^*$ demeurant dans l'état métastable, faisceau qui pourrait également être utilisé, après avoir ionisé puis dévié lesdits atomes He$^*$.

De préférence, la taille des motifs du masque 73, c'est-à-dire dans le cas présent la taille des domaines transparents qui séparent les domaines opaques dudit masque, est choisie de manière à ne provoquer qu'une faible diffraction lumineuse. Pour ce faire, on peut réaliser sur le masque 73, des motifs de taille supérieure à la longeur d'onde de la lumière issue de la source lumineuse 70, c'est-à-dire des motifs de l'ordre de 1 µm ou plus dans l'exemple considéré, pour lequel la lumière utilisée a une longueur d'onde de 0,260µm. Malgré cette condition imposée au masque 73, les motifs réalisés sur le circuit 80 peuvent être bien plus petits que les motifs du masque 73, étant donné la convergence du faisceau 79 d'ions He$^+$, résultant elle-même de la convergence donnée au faisceau primaire 56 (figure 6). Cette convergence peut être déterminée à partir de la taille des motifs que l'on souhaite réaliser sur le circuit 80.

Bien entendu, le dispositif selon l'invention représenté sur la figure 6 pourrait être adapté à l'utilisation d'une source d'ions négatifs. En outre, la neutralisation des ions pourrait être effectuée autrement que par contact avec des atomes de même espèce chimique que lesdits ions, par exemple par un flux d'électrons ayant la même vitesse que lesdits ions.

La présente invention n'est pas limitée à l'obtention de faisceaux de particules de densité spatialement modulée de façon discontinue, aux moyen de masques présentant des domaines opaques à la lumière employée, séparés par des domaines transparents à cette lumière. L'invention permet également d'obtenir des faisceaux de particules de densité modulée de façon continue, en utilisant des masques d'opacité variable en fonction des points considérés sur ces masques.

Les masques permettant une modulation spatiale discontinue de l'intensité des faisceaux lumineux qui les traversent peuvent être par exemple obtenus en déposant une couche mince absorbante sur un substrat transparent et en enlevant ensuite les parties souhaitées par les techniques bien connues de la photolithogravure.

Les masques permettant une modulation spatiale' continue de l'intensité des faisceaux lumineux qqui les traversent peuvent être par exemple obtenus par dépôt d'une couche opaque sur un support transparent puis photolithogravure au cours de laquelle l'attaque de la couche déposée est interrompue avant disparition totale de cette couche. Bien entendu, un grand nombre de particules autres que les atomes de gaz rares sont utilisables dans l'invention: on peut par exemple employer un faisceau primaire d'atomes de mercure, le mercure atomique ayant deux niveaux métastables, le premier à 4,67 eV et le deuxième à 5,46 eV, ainsi qu'un niveau d'ionisation à 10,43 eV.

On peut enfin donner, à titre indicatif mais nullement limitatif, un exemple de mise en oeuvre du second mode de réalisation du procédé objet de l'invention : on crée un faisceau d'ions négatifs, par exemple un faisceau d'ions H-; on envoie un faisceau de photons d'intensité convenablement modulée spatialement sur ce faisceau d'ions négatifs, de façon à faire passer sélectivement (au sens spatial du terme) une partie des ions négatifs à un état neutre (métastable ou fondamental), par une réaction dite de "photo-detachment" selon la terminologie anglo-saxonne, l'énergie des photons servant à rompre la liaison entre les atomes H et les électrons rajoutés à ces derniers; et l'on sépare les ions H restants des atomes d'hydrogène à l'état neutre formés.

## Revendications

1. Procédé d'obtention de faisceaux de particules de densité spatialement modulée, caractérisé en ce qu'il consiste:
- à faire passer les particules d'un faisceau primaire (3, 56) de particules à un premier état énergétique $E_1$, de manière à former un faisceau de particules se ttrouvant dans ledit premier état energétique $E_1$,
- à faire passer sélectivement les particules se trouvant dans ledit premier état énergétique $E_1$ à un second état énergétique $E_2$ à l'aide d'un flux lumineux (7, 40, 72) d'intensité spatialement modulée, dirigé sur le faisceau de particules se trouvant dans ledit premier état énergétique $E_1$, et
- a séparer les particules se trouvant dans ledit second état énergétique $E_2$ des particules se trouvant dans ledit premier état énergétique $E_1$ de manière à obtenir un faisceau formé des particules se trouvant dans ledit premier état énergétique $E_1$ et un faisceau formé des particules se trouvant dans ledit second état énergétique $E_2$, ces faisceaux ètant distincts et de densité spatialement modulée,
en ce que l'un desdits premier et second états énergétiques $E_1$ et $E_2$ est un état énergétique de longue durée de vie et en ce que l'autre état énergétique est un état ionisé dont l'état d'ionisation diffère de celui de l'état énergétique de longue durée de vie.

2. Procédé selon la revendication 1, caractérisé en ce que ledit état énergétique de longue durée de vie est un état excité métastable.

3. Procédé selon la revendication 2, caractérisé en ce que les particules du faisceau primaire (3, 56) sont électriquement neutres et dans leur état fondamental, et en ce que l'on fait passer ces particules audit état excité métastable, à partir de leur état fondamental, par bombardement électronique, ledit premier état énergétique $E_1$ étant constitué par ledit état excité métastable et ledit état énergétique $E_2$ étant alors ledit état ionisé.

4. Procédé selon la revendication 2, caractérisé en ce que les particules du faisceau primaire (3, 56) sont électriquement chargées et en ce que l'on fait passer ces particules audit état excité métastable par bombardement électronique, après avoir neutralisé les particules du faisceau primaire (3, 56) par échange de charges dans un gaz de particules du même type, ledit premier état énergétique $E_1$ étant constitué par ledit état excité métastable et ledit second état énergétique $E_2$ étant alors ledit état ionisé.

5. Procédé selon l'une quelconque des revendications 1 à 4, caractérisé en ce que ledit état ionisé est l'état de première ionisation.

6. Procédé selon l'une quelconque des revendications 1 à 5, caractérisé en ce que les particules se trouvant dans ledit état ionisé sont séparées des particules se trouvant dans ledit état énergétique de longue durée de vie à l'aide d'au moins l'un des champs pris dans le groupe comprenant les champs électriques et les champs magnétigues.

7. Procédé selon l'une quelconque des revendications 1 à 6, caractérisé en ce que l'intensité du flux lumineux (7, 40, 72) est modulée spatialement par passage dudit flux lumineux à travers un masque (8, 41, 73).

8. Procédé selon l'une quelconque des revendications 1 à 6, caractérisé en ce que la modulation spatiale d'intensité du flux lumineux est obtenue par une méthode fondée sur la nature ondulatoire de la lumière.

9. Procédé selon la revendication 8, caractérisé en ce que le flux lumineux d'intensité modulée est obtenu en dirigeant vers l'axe du faisceau de particules se trouvant dans ledit premier état énergétique $E_1$ deux faisceaux de lumière cohérente issus du même faisceau lumineux primaire, ceci de façon symétrique par rapport à l'axe du faisceau de particules se trouvant dans ledit premier état énergétique $E_1$, de façon à obtenir ainsi des zones alternativement lumineuses et sombres parallèles à l'axe du faisceau de particules se trouvant dans ledit premier état énergétique $E_1$.

10. Procédé selon l'une quelconque des revendications 1 à 9, caractérisé en ce que lesdites particules sont des atomes d'au moins un gaz rare.

11. Dispositif d'obtention de faisceaux de particules de densité spatialement modulée, caractérisé en ce qu'il comprend:
- des moyens (2, 55) pour produire un faisceau primaire (3, 56) de particules,
- des moyens pour faire passer les particules de ce faisceau primaire à un premier état énergétique $E_1$ de manière à former un faisceau (5, 36, 69) de particules se trouvant dans ledit premier état énergétique $E_1$,
- des moyens (6 ou 38, 39 ou 70, 71) pour produire un flux lumineux (7, 40, 72) composé de photons aptes à faire passer les particules se trouvant dans ledit premier état énergétique $E_1$, à un second état énergétique $E_2$, et pour diriger ce flux lumineux (7, 40, 72) sur le faisceau de particules se trouvant dans le premier état énergétique $E_1$,
- des moyens (8, 41, 73) de modulation spatiale de l'intensité dudit flux lumineux, interposés entre les moyens pour produire et diriger ce flux lumineux et le faisceau de particules se trouvant dans le premier état énergétique $E_1$, de manière à faire passer sélectivement les particules se trouvant dans le premier état énergétique $E_1$ au second état énergétique $E_2$, et
- des moyens (9 ou 43, 44 ou 75) de séparation des particules se trouvant dans le second état énergétique $E_2$, des particules se trouvant dans le premier état énergétique $E_1$, de façon à obtenir un faisceau (21, 45, 79) formé des particules se trouvant dans le premier état énergétique $E_1$ et un faisceau (22, 49, 81) formé des particules se trouvant dans le second état énergétique $E_2$, ces faisceaux étant distincts et de densité spatialement modulée, l'un des premier et second états énergétiques $E_1$ et $E_2$ étant un état énergétique de longue durée de vie et l'autre état énergétique étant un état ionisé dont l'état d'ionisation diffère de celui de l'état énergétique de longue durée de vie.

12. Dispositif selon la revendication 11, comprenant:
- des moyens (2, 55) pour produire un faisceau primaire (3, 56) de particules,
- des moyens pour faire passer les particules de ce faisceau primaire (3, 56), à un état énergétique de longue durée de vie, de manière à former un faisceau (5, 36, 69) de particules se trouvant dans ledit état énergétique de longue durée de vie,
- des moyens (6 ou 38, 39 ou 70, 71) pour produire un flux lumineux (7, 40, 72) composé de photons aptes à ioniser les particules se trouvant dans ledit état énergétique de longue durée de vie, et pour diriger ce flux lumineux (7, 40, 72) sur ledit faisceau (5, 36, 69) de particules se trouvant dans ledit état énergétique de longue durée de vie,
- des moyens (8, 41, 73) de modulation spatiale de l'intensité dudit flux lumineux (7, 40, 72), interposés entre les moyens (6 ou 38, 39 ou 70, 71) pour produire et diriger ce flux lumineux et le faisceau (5, 36, 69) de particules se trouvant dans ledit état énergétique de longue durée de vie, de manière à faire passer sélectivement les particules se trouvant dans ledit état énergétique de longue durée de vie, à un état ionisé, et
- des moyens (9 ou 43, 44 ou 75) de séparation des particules se trouvant dans ledit état ionisé, des particules demeurant dans ledit état énergétique de longue durée de vie, de façon à obtenir un faisceau (21, 45, 79) formé des particules se trouvant dans ledit état ionisé et un faisceau (22, 46, 81) formé des particules demeurant dans ledit état énergétique de longue durée de vie, ces faisceaux étant distincts et de densité spatialement modulée, l'état ionisé ayant un état d'ionisation différent de celui de l'état énergétique de longue durée de vie.

13. Dispositif selon la revendication 12, caractérisé en ce que ledit flux lumineux (7) est constitué par au moins un faisceau lumineux qui est dirigé vers le faisceau (5) de particules se trouvant dans ledit état énergétique de longue durée de vie, transversalement à celui-ci.

14. Dispositif selon la revendication 12, caractérisé en ce que le flux lumineux (40) est un faisceau lumineux, en ce que ce dernier ainsi que le faisceau (36) de particules se trouvant dans ledit état énergétique de longue durée de vie sont colinéaires et ont des sens de propagation opposés et en ce que le dispositif comporte en outre successivement des moyens d'ionisation (48), des moyens d'accélération (49) et des moyens de déviation (50) du faisceau (46) des particules demeurant dans ledit état énergétique de longue durée de vie.

15. Dispositif selon la revendication 12, caractérisé en ce que le flux lumineux est un faisceau lumineux, en ce que le faisceau (69) de particules se trouvant dans ledit état énergétique de longue durée de vie et le faisceau lumineux (72) sont prévus pour se propager selon une même direction et selon des sens opposés, en ce que le faisceau (69) de particules se trouvant dans ledit état énergétique de longue durée de vie est rendu convergent selon un angle $\alpha$, en ce que le faisceau lumineux (72) est rendu divergent selon le même angle $\alpha$ et prevu en outre pour être confondu avec le faisceau (69) de particules se trouvant dans ledit état énergétique de longue durée de vie, et en ce que les moyens (75) de séparation consistent en des moyens de déviation des particules se trouvant dans ledit état ionisé.

16. Dispositif selon la revendication 15, caractérisé en ce que les moyens (73) de modulation spatiale de l'intensité du faisceau lumineux consistent en un masque pourvu de motifs dont la taille est prévue pour que ces motifs n'entraînent qu'une faible diffraction lumineuse.

17. Application du procédé selon l'une quelconque des revendications 1 à 10, à la gravure et à l'implantation ioniques.

**Patentansprüche**

1. Verfahren zur Erzeugung von Teilchenstrahlen mit räumlich modulierter Dichte, dadurch gekennzeichnet, daß es enthält:

Überführen der Teilchen eines primären Teilchenstrahls (3, 56) in einen ersten energetischen Zustand $E_1$, um einen Teilchenstrahl zu bilden, der sich in dem genannten ersten energetischen Zustand $E_1$ befindet,

selektives Überleiten der sich in dem ersten energetischen Zustand $E_1$ befindlichen Teilchen in einen zweiten energetischen Zustand $E_2$ mit Hilfe eines Lichtflusses (7, 40, 72) räumlich modulierter Intensität, der auf den sich im ersten energetischen Zustand $E_1$ befindlichen Teilchenstrahl gerichtet ist, und

Abtrennen der sich in dem zweiten energetischen Zustand $E_2$ befindlichen Teilchen von den sich in dem ersten energetischen Zustand $E_1$ befindlichen Teilchen, um einen Strahl zu erhalten, der aus Teilchen gebildet ist, die sich in dem ersten energetischen Zustand $E_1$ befinden, und um einen Strahl zu erhalten, der aus Teilchen gebildet ist, die sich in dem zweiten energetischen Zustand $E_2$ befinden, wobei diese Strahlen voneinander verschieden sind und räumlich modulierte Dichte haben,

und daß der eine der ersten und zweiten energetischen Zustände $E_1$ und $E_2$ ein energetischer Zustand langer Lebensdauer ist und daß der andere energetische Zustand ein ionisierter Zustand ist, dessen Ionisationszustand von dem des energetischen Zustands langer Lebensdauer abweicht.

2. Verfahren nach Anspruch 1, dadurch gekennzeichnet, daß der energetische Zustand langer Lebensdauer ein metastabil erregter Zustand ist.

3. Verfahren nach Anspruch 2, dadurch gekennzeichnet, daß die Teilchen des Primärstrahls (3, 56) elektrisch neutral und in ihrem Grundzustand sind, und daß man diese Teilchen in den metastabil erregten Zustand von ihrem Grundzustand ausgehend durch elektronische Bombardierung überführt, wobei der erste energetische Zustand $E_1$ von dem metastabil erregten Zustand gebildet wird und der genannte energetische Zustand $E_2$ somit der ionisierte Zustand ist.

4. Verfahren nach Anspruch 2, dadurch gekennzeichnet, daß die Teilchen des Primärstrahles (3, 56) elektrisch geladen sind, und daß man diese Teilchen durch elektronische Bombardierung in den genannten metastabil erregten Zustand überführt, nachdem man die Teilchen des Primärstrahles (3, 56) durch Ladungsaustausch in einem Gas aus Teilchen desselben Typs neutralisiert hat, wobei der erste energetische Zustand $E_1$ von dem metastabil erregten Zustand gebildet wird und der genannte zweite energetische Zustand $E_2$ dann der ionisierte Zustand ist.

5. Verfahren nach einem der Ansprüche 1 bis 4, dadurch gekennzeichnet, daß der ionisierte Zustand der Zustand der Erstionisation ist.

6. Verfahren nach einem der Ansprüche 1 bis 5, dadurch gekennzeichnet, daß die Teilchen, die sich in dem genannten ionisierten Zustand befinden, von den Teilchen, die sich in dem energetischen Zustand langer Lebensdauer befinden, mit Hilfe wenigstens einem der Felder getrennt werden, das aus der Gruppe genommen ist, die die elektrischen Felder und die magnetischen Felder enthält.

7. Verfahren nach einem der Ansprüche 1 bis 6, dadurch gekennzeichnet, daß die Intensität des Lichtflusses (7, 40, 72) räumlich durch Durchleiten des genannten Lichtflusses durch eine Maske (8, 41, 73) moduliert wird.

8. Verfahren nach einem der Ansprüche 1 bis 6, dadurch gekennzeichnet, daß die räumliche Modulation der Intensität des Lichtflusses durch ein Verfahren erhalten wird, das sich auf die Wellennatur des Lichts gründet.

9. Verfahren nach Anspruch 8, dadurch gekennzeichnet, daß der Lichtfluß modulierter Intensität erhalten wird, indem man gegen die Achse des Strahls der Teilchen, die sich in dem ersten energetischen Zustand $E_1$ befinden, zwei Strahlen kohärenten Lichts richtet, die von demselben Primärlichtbündel abgegeben werden, und zwar symmetrisch in bezug auf die Achse des Strahls der sich im ersten energetischen Zustand $E_1$ befindlichen Teilchen, um auf diese Weise abwechselnd helle und dunkle Zonen parallel zur Achse des Strahls der sich im ersten energetischen Zustand $E_1$ befindlichen Teilchen zu erhalten.

10. Verfahren nach einem der Ansprüche 1 bis 9, dadurch gekennzeichnet, daß die genannten Teilchen Atome wenigstens eines Edelgases sind.

11. Vorrichtung zum Erzeugen von Teilchenstrahlen räumlich modulierter Dichte, dadurch gekennzeichnet, daß sie enthält:

eine Einrichtung (2, 55) zum Erzeugen eines primären Teilchenstrahls (3, 56),

eine Einrichtung zum Überleiten der Teilchen dieses Primärstrahls in einen ersten energetischen Zustand $E_1$, um einen Teilchenstrahl (5, 36, 69) zu bilden, der sich in einem ersten energetischen Zustand $E_1$ befindet,

eine Einrichtung (6 oder 38, 39 oder 70, 71) zum Erzeugen eines Lichtflusses (7, 40, 72), der aus Photonen besteht, die dazu eingerichtet sind, die Teilchen, die sich in dem ersten energetischen Zustand $E_1$ befinden, in einen zweiten energetischen Zustand $E_2$ zu überführen und um diesen Lichtfluß (7, 40, 72) auf den Teilchenstrahl zu richten, der sich in dem ersten energetischen Zustand $E_1$ befindet,

12

eine Einrichtung (8, 41, 73) zur räumlichen Modulation der Intensität des genannten Lichtflusses, die zwischen der Einrichtung zum Erzeugen und Richten des Lichtflusses und dem Teilchenstrahl angeordnet ist, der sich in dem ersten energetischen Zustand $E_1$ befindet, um selektiv die Partikel, die sich in dem ersten energetischen Zustand $E_1$ befinden, in den zweiten energetischen Zustand $E_2$ zu überführen, und

eine Einrichtung (9 oder 43, 44 oder 75) zum Abtrennen der Teilchen, die sich in dem zweiten energetischen Zustand $E_2$ befinden, von den Teilchen, die sich in dem ersten energetischen Zustand $E_1$ befinden, um einen Strahl (41, 45, 79) zu erhalten, der aus Partikeln gebildet ist, die sich in dem ersten energetischen Zustand $E_1$ befinden, und einen Strahl (22, 49, 81) zu erhalten, der aus Partikeln gebildet ist, die sich in dem zweiten energetischen Zustand $E_2$ befinden, wobei diese Strahlen voneinander verschieden sind und in ihrer räumlichen Dichte moduliert sind.

12. Vorrichtung nach Anspruch 11, enthaltend:

eine Einrichtung (2, 55) zum Erzeugen eines primären Teilchenstrahls (3, 56),

eine Einrichtung zum Überführen der Teilchen dieses Primärstrahls (3, 56) in einen energetischen Zustand langer Lebensdauer, um einen Strahl (5, 36, 69) aus Partikeln zu bilden, die sich in dem genannten energetischen Zustand langer Lebensdauer befinden,

eine Einrichtung (6 oder 38, 39 oder 70, 71) zum Erzeugen eines Lichtflusses (7, 40, 72), der aus Photonen besteht, die dazu geeignet sind, die Partikel zu ionisieren, die sich in dem genannten energetischen Zustand langer Lebensdauer befinden, und um diesen Lichtfluß (7, 40, 72) auf den genannten Strahl (5, 36, 69) aus Partikeln, die sich in dem genannten energetischen Zustand langer Lebensdauer befinden, zu richten,

eine Einrichtung (8, 41, 73) zur räumlichen Modulation der Intensität des genannten Lichtflusses (7, 40, 72), die zwischen der Einrichtung (6 oder 38, 39 oder 70, 71) zum Erzeugen und Richten des Lichtflusses und dem Strahl (5, 36, 69) aus sich in dem energetischen Zustand langer Lebensdauer befindenden Partikel angeordnet ist, um selektiv die Partikel, die sich in dem genannten energetischen Zustand langer Lebensdauer befinden, in einen ionisierten Zustand zu überführen, und

eine Einrichtung (9 oder 43, 44 oder 75) zum Abtrennen der Teilchen, die sich in dem genannten ionisierten Zustand befinden, von den Partikeln, die sich in dem genannten energetischen Zustand langer Lebensdauer befinden, um einen Strahl (21, 45, 79) zu erhalten, der aus Teilchen gebildet ist, die sich in dem genannten ionisierten Zustand befinden, und einen Strahl (22, 46, 81) zu erhalten, der von Teilchen gebildet ist, die in dem genannten energetischen Zustand langer Lebensdauer verbleiben, wobei diese Strahlen voneinander verschieden sind und eine räumlich modulierte Dichte aufweisen, wobei der Ionisierungszustand einen Ionisationszustand hat, der sich von dem des energetischen Zustands langer Lebensdauer unterscheidet.

13. Vorrichtung nach Anspruch 12, dadurch gekennzeichnet, daß der Lichtfluß (7) von wenigstens einem Lichtstrahl gebildet ist, der quer gegen den Strahl (5) aus Partikeln gerichtet ist, die sich in dem energetischen Zustand langer Lebensdauer befinden.

14. Vorrichtung nach Anspruch 12, dadurch gekennzeichnet, daß der Lichtfluß (40) ein Lichtstrahl ist, und daß letzterer sowie der Strahl (36) aus sich im energetischen Zustand langer Lebensdauer befindlichen Partikel kolinear sind und einander entgegengesetzte Ausbreitungsrichtung haben und daß die Vorrichtung weiterhin aufeinanderfolgend eine Ionisationseinrichtung (48), eine Beschleunigungseinrichtung (49), eine Ablenkeinrichtung (50) für den Strahl (46) aus Partikeln aufweist, die in dem genannten energetischen Zustand langer Lebensdauer verbleiben.

15. Vorrichtung nach Anspruch 12, dadurch gekennzeichnet, daß der Lichtfluß ein Lichtstrahl ist, und daß der Strahl (49) aus sich im energetischen Zustand langer Lebensdauer befindlichen Partikel und der Lichtstrahl (72) dazu vorgesehen sind, sich in derselben Richtung und in entgegengesetztem Sinn fortzupflanzen, und daß der Strahl (69) aus sich im energetischen Zustand langer Lebensdauer befindlichen Partikel mit einem Winkel $\alpha$ konvergiert, und daß der Lichtstrahl (72) mit dem gleichen Winkel $\alpha$ divergiert und weiterhin dazu vorgesehen ist, mit dem Strahl (69) aus sich im energetischen Zustand langer Lebensdauer befindlichen Partikel zu verschmelzen, und daß die Trenneinrichtung (75) aus einer Ablenkeinrichtung für Partikel besteht, die sich in dem genannten ionisierten Zustand befinden.

16. Vorrichtung nach Anspruch 15, dadurch gekennzeichnet, daß die Einrichtung (73) zur räumlichen Modulation der Intensität des Lichtstrahls aus einer Maske besteht, die mit Motiven versehen ist, deren Größe so gewählt ist, daß diese Motive nur eine schwache Lichtbeugung zur Folge haben.

17. Anwendung des Verfahrens nach einem der Ansprüche 1 bis 10 auf die Gravierung und auf die Ionenimplantation.

## Claims

1. Process for obtaining beams of particles of spatially modulated density, characterized in that it consists in:

causing the particles of a primary beam (3, 56) of particles to pass to a first energy state $E_1$, in such a manner as to form a beam of particles situated in the said first energy state $E_1$,

selectively causing the particles situated in the said first energy state $E_1$ to pass to a second energy state $E_2$ by a means of a luminous flux (7, 40, 72) which is of spatially modulated intensity and which is directed onto the beam of particles situated in the said first energy state $E_1$, and

separating the particles situated in the said second energy state $E_2$ from the particles situated in the said first energy state $E_1$ in such a manner as to obtain a beam formed of the particles situated in the said first energy state $E_1$ and a beam formed of the particles situated in the said second energy state $E_2$, these beams being distinct and of spatially modulated density, in that one of the said first and second energy states $E_1$ and $E_2$ is an energy state of long lifetime, and in that the other energy state is an ionized state, the state of ionization of which differs from that of the energy state of long lifetime.

2. Process according to claim 1, characterized in that said energy state of long lifetime is a metastable excited state.

3. Process according to claim 2, characterized in that the particles of the primary beam (3, 56) are electrically neutral and in their fundamental state, and in that these particles are caused to pass to the said metastable excited state, from their fundamental state, by electron bombardment, the said first energy state $E_1$ being constituted by the said metastable excited state and the said energy state $E_2$ then being the said ionized state.

4. Process according to claim 2, characterized in that the particles of the primary beam (3, 56) are electrically charged, and in that these particles are caused to pass to the said metastable excited state by electron bombardment, after having neutralized the particles of the primary beam (3, 56) by exchange of charges in a gas of particles of the same type, the said first energy state $E_1$ being constituted by the said metastable excited state and the said second energy state E2 then being the said ionized state.

5. Process according to any one of claims 1 to 4, characterized in that the said ionized state is the state of first ionization.

6. Process according to any one of claims 1 to 5, characterized in that the particles situated in the said ionized state are separated from the particles situated in the said energy state of long lifetime by means of at least one of the fields included in the group comprising the electric fields and the magnetic fields.

7. Process according to any one of claims 1 to 6, characterized in that the intensity of the luminous flux (7, 40, 72) is spatially modulated by passage of the said luminous flux through a mask (8, 41, 73).

8. Process according to any one of claims 1 to 6, characterized in that the spatial modulation of intensity of the luminous flux is obtained by a method based on the wave nature of the light.

9. Process according to claim 8, characterized in that the luminous flux of modulated intensity is obtained by directing towards the axis of the beam of particles situated in the said first energy state $E_1$ two beams of coherent light which have emerged from the same primary luminous beam, this taking place in a symmetrical manner in relation to the axis of the beam of particles situated in the said first energy state $E_1$, in such a manner as thus to obtain alternately bright and dark zones parallel to the axis of the beam of particles situated in the said first energy state $E_1$.

10. Process according to any one of claims 1 to 9, characterized in that the said particles are atoms of at least one rare gas.

11. Device for obtaining beams of particles of spatially modulated density, characterized in that it comprises:

means (2, 55) for producing a primary beam (3, 56) of particles,

means for causing the particles of this primary beam to pass into a first energy state $E_1$ in such a manner as to form a beam (5, 36, 69) of particles situated in the said first energy state $E_1$,

means (6 or 38, 39 or 70, 71) for producing a luminous flux (7, 40, 72) composed of photons capable of causing the particles situated in the said first energy state $E_1$ to pass into a second energy state $E_2$ and for directing this luminous flux (7, 40, 72) onto the beam of particles situated in the first energy state $E_1$,

means (8, 41, 73) for spatial modulation of the intensity of the said luminous flux, the said means being interposed between the means for producing and directing this luminous flux and the beam of particles situated in the first energy state $E_1$ in such a manner as selectively to cause the particles situated in the first energy state $E_1$ to pass into the second energy state $E_2$ and

means (9 or 43, 44 or 75) for separation of the particles situated in the second energy state $E_2$ from the particles situated in the first energy state $E_1$, in such a manner as to obtain a beam (21, 45, 79) formed of the particles situated in the first energy state $E_1$ and a beam (22, 49, 81) formed of the particles situated in the second energy state $E_2$, these beams being distinct and of spatially modulated density,

one of the first and second energy states $E_1$ and $E_2$ being an energy state of long lifetime and the other energy state being an ionized state, the state of ionization of which differs from that of the energy state of long lifetime.

12. Device according to claim 11, comprising:

means (2, 55) for producing a primary beam (3, 56) of particles

means for causing the particles of this primary beam (3, 56) to pass into an energy state of long lifetime, in such a manner as to form a beam (5, 36, 69) of particles situated in the said energy state of long lifetime,

means (6 or 38, 39 or 70, 71) for producing a luminous flux (7, 40, 72) composed of photons capable of ionizing the particles situated in the said energy state of long lifetime, and for directing this luminous flux (7, 40, 72) onto the said beam (5, 36, 69) of particles situated in the said energy state of long lifetime,

means (8, 41, 73) for spatial modulation of the intensity of the said luminous flux (7, 40, 72), the said means being interposed between the means (6 or 38, 39 or 70, 71) for producing and directing this luminous flux and the beam (5, 36, 69) of particles situated in the said energy state of long lifetime, in such a manner as to cause the particles situated in the said energy state of long lifetime to pass selectively into an ionized state, and

means (9 or 43, 44 or 75) for separation of the particles situated in the said ionized state from the particles remaining in the said energy state of long lifetime, in such a manner as to obtain a beam (21, 45, 79) formed of the particles situated in the said ionized state and a beam (22, 46, 81) formed of the particles remaining in the said energy state of long lifetime, these beams being distinct and of spatially modulated density, the ionized state having a state of ionization different from that of the energy state of long lifetime.

13. Device according to claim 12, characterized in that the said luminous flux (7) is constituted by at least one luminous beam which is directed towards the beam (5) of particles situated in the said energy state of long lifetime, transversely thereto.

14. Device according to claim 12, characterized in that the luminous flux (40) is a luminous beam, in that the latter and the beam (36) of particles situated in the said energy state of long lifetime are collinear and have opposite directions of propagation, and in that the device further comprises successively means for ionization (48), means for acceleration (49) and means for deviation (50) of the beam (46) of the particles remaining in the said energy state of long lifetime.

15. Device according to claim 12, characterized in that the luminous flux is a luminous beam, in that the beam (69) of particles situated in the said energy state of long lifetime and the luminous beam (72) are provided to propagate according to the same direction and in opposite senses, in that the beam (69) of particles situated in the said energy state of long lifetime is made convergent according to an angle $\alpha$, in that the luminous beam (72) is made divergent according to the same angle $\alpha$ and, moreover, provided to be coincident with the beam (69) of particles situated in the said energy state of long lifetime, and in that the means (75) for separation consist in means for deviation of the particles situated in the said ionized state.

16. Device according to claim 15, characterized in that the means (73) for spatial modulation of the intensity of the luminous beam consist in a mask provided with patterns, the size of which is provided in order that these patterns should give rise to only a slight luminous diffraction.

17. Application of the process according to any one of claims 1 to 10 to ion implantation and engraving.

FIG. 1

FIG. 2

FIG. 3a

FIG. 3b

FIG. 5b

FIG. 5a

FIG. 4

FIG. 6

FIG. 7